# EUROPEAN PATENT APPLICATION

(11) **EP 1 276 147 A2**
(43) Date of publication of application: **15.01.2003**
(21) Application number: 02100795.0
(22) Date of filing: 09.07.2002
(51) Int. Cl.: H01L 21/768

(54) **Dual hardmask process for the formation of copper/low-K interconnects**

(30) Priority: 09.07.2001 US 901416
(71) Applicant: Texas Instruments Incorporated, Dallas, Texas 75251 (US)
(72) Inventor: XING, Guoqiang, 75093, Plano (US); BRENNAN, Kenneth D., 78748, Austin (US); JIANG, Ping, 75024, Plano (US)
(74) Representative: Holt, Michael

(57) **Abstract**

The invention describes a method for forming integrated circuit interconnects using a dual hardmask dual damascene process. A first hardmask layer (50) and a second hardmask layer (60) are formed over a low k dielectric layer (40). The trench pattern is first defined by the second hardmask and via pattern is then defined by the first hardmask. Any interaction between low k dielectrics (40) and the photoresist (80) at patterning is prevented. The BARC and photoresist may be stripped before the start of the dielectric etching such that the low k dielectric material is protected by the hardmasks during resist strip.

## Description

### FIELD OF THE INVENTION

The invention is generally related to the field of semiconductor devices and fabrication and more specifically to a method for forming copper lines in integrated circuits using a dual hardmask process.

### BACKGROUND OF THE INVENTION

To increase the operating speed, high performance integrated circuits use copper interconnect technology along with low dielectric constant (low k) dielectrics. Currently the damascene method is the most widely used method for forming copper interconnects. In a via-first dual damascene process, an ILD layer is deposited first, followed by an IMD deposition. An IMD etch-stop layer, such as SiN or SiC, can be optionally used in between IMD and ILD. A via is patterned and etched through the IMD and ILD for connection to lower interconnect levels. Then a trench is patterned and etched in the IMD. A barrier layer and a copper seed layer are then deposited over the structure. The barrier layer is typically tantalum nitride or some other binary transition metal nitride. The copper layer is electrochemically deposited (ECD) using the seed layer over the entire structure. The copper is then chemically-mechanically polished (CMP'd) to remove the copper over the IMD, leaving copper interconnect lines and vias.

During the damascene process a number of photolithograph, etch, and clean-up processes are used. Using the low k dielectric films, a number of unwanted interactions occur between these films and the photolithograph, etch, and clean-up processes. The dry etching of the low k dielectrics, such as organosilicate glass (OSG), often has poor selectivity to photoresist. The selectivity is worsened when 193nm photoresist is used for patterning smaller vias or trenches. Resist erosion during etch can lead to trench and via flaring, and pitting of the dielectric surface. The severity of the problem increases during etch-stop etch and pre-sputter etch when no mask is present to protect the dielectric layer. Severe trench and via flaring, and surface pitting can result in metal shorts. In addition, certain low k material may interact with photoresist and cause resist poisoning. Resist poisoning occurs when chemicals present in low k dielectrics, specifically nitrogen-containing species, diffuse into photoresist films changing the photosensitivity of the photoresist films. This results in large areas of undeveloped photoresist after the photoresist patterning process. Additional constrains must be applied when ultra-low k dielectrics, often in porous forms, are used in damascene integration schemes. Many of these ultra-low k materials can not be subjected to photoresist ash or wet clean process without irreversible property change. For this reason, a dual hardmask integration scheme is used. Various methods have been utilized to try and reduce the interactions including the use of silicon nitride and silicon carbide hardmasks. A major limitation restricting the use of these various hardmasks is the low etch rate selectivity between the low k dielectric layers and these hardmask layers. Typical etch rate selectivity is in the range of ∼ 1:3 to 1:8. There is therefore a need for an improved methodology for forming copper interconnects in integrated circuits, specifically the hardmask selection.

### SUMMARY OF THE INVENTION

The present invention describes a dual hardmask process for forming integrated circuit interconnects. Multiple hardmask layers are formed on the upper surface of a single or multiple dielectric layer(s). The dielectric layer or layers is/are formed over a silicon wafer containing numerous electronic devices. A first hardmask is formed on the dielectric layer. This first hardmask comprises silicon carbide or silicon nitride. A second hardmask layer is formed on the first hardmask layer. The second hardmask layer comprises a material selected from the group consisting of titanium aluminide (TiAl), titanium aluminum nitride (TiAlN), titanium nitride (TiN), aluminum nitride (AlN), tantalum aluminide (TaAl), and tantalum aluminum nitride (TaAlN). A patterned photoresist layer and a BARC layer are formed on the second hard mask layer. Following the etching of the second hardmask layer, a new patterned photoresist layer and a new BARC layer are formed. A first trench is etched in the dielectric layer using the second hardmask and/or the photoresist as an etch mask. The exposed portion of the first hardmask is removed and, using the second hardmask as an etch mask, a second trench is formed while simultaneous further etching the first trench.

### BRIEF DESCRIPTION OF THE DRAWINGS

FIGURES 1(a) - 1(f) are cross-sectional diagrams illustrating a first embodiment of the instant invention.
FIGURES 2(a) - 2(g) are cross-sectional diagrams illustrating a second embodiment of the instant invention.

### DETAILED DESCRIPTION OF THE INVENTION

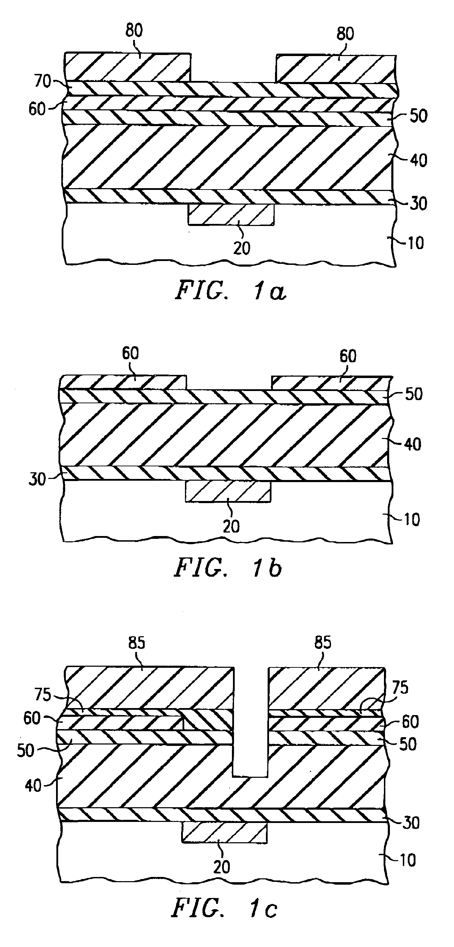

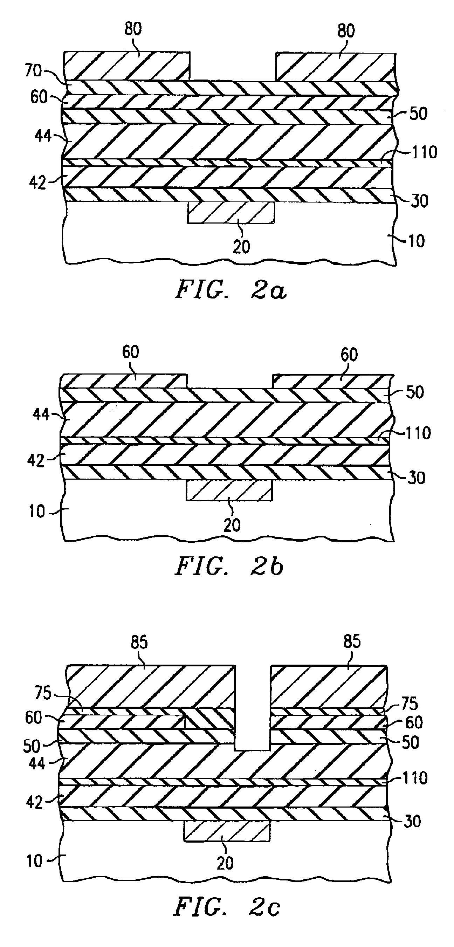

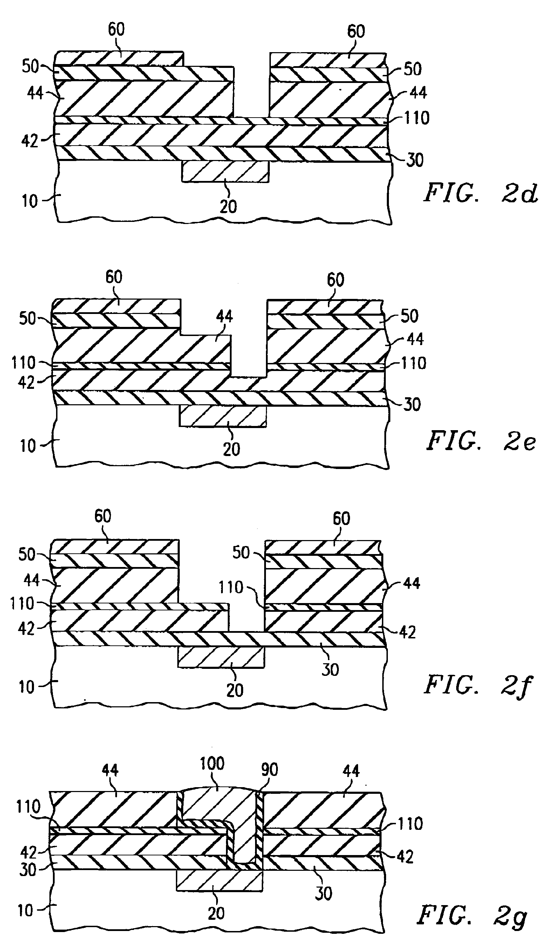

The invention will now be described with reference to Figures 1(a)-1(f) and 2(a)-2(g). It will be apparent to those of ordinary skill in the art that the benefits of the invention can be applied to other structures where a damascene process is utilized.

The requirement of higher clock speed has lead to the use of copper to form the metal interconnect lines in integrated circuits. In addition to the use of copper, dielectric layers such as organosilicate glass (OSG) (dielectric constant ∼2.7 - 3.0) is currently being used to take advantage of the lower dielectric constant of such materials compared to silicon dioxide. In an embodiment of the instant invention, an etch stop layer 30 is formed over a copper layer 20 and a dielectric layer 10. The dielectric layer 10 is formed over a silicon substrate containing various electronic devices such as transistors, diodes, etc. The copper layer 20 represents a portion of the copper interconnect of an integrated circuit which is made up of the electronic devices contained in the silicon substrate. In a multi-level interconnect scheme, layers 10 and 20 described here generally represent the previous interconnect level. The etch stop layer may comprise silicon nitride (SiN), silicon carbide (SiC), or any suitable material with good etch selectivity and preferably low dielectric constant. Following the formation of the etch stop layer 30, a low k dielectric layer 40 with a low dielectric constant (i.e. less that 3.0) is formed over the etch stop layer 30. In an embodiment of the instant invention this low k dielectric layer 40 comprises organosilicate glass (OSG) which has a dielectric constant of about 2.8. In addition to OSG films, any suitable low k dielectric material may be used to form the dielectric layer 40. Following the formation of the low k dielectric layer 40, a first hardmask layer 50 is formed. This first hardmask layer 50 comprises a material selected -from the group consisting of silicon carbide (SiC), silicon nitride (SiN), and any other suitable material. Following the formation of the first hardmask layer 50, a second hardmask layer 60 is formed over the first hardmask layer. This second hardmask layer comprises a material selected from the group consisting of titanium aluminide (TiAl), titanium aluminum nitride (TiAlN), titanium nitride (TiN), aluminum nitride (AlN), tantalum aluminide (TaAl), tantalum aluminum nitride (TaAlN), or any combination of layers of these various alloys. In an embodiment of the instant invention Ti₍₁₋ₓ₎AlₓN is used with x varying from 0 to 100% and more preferably from 25% to 40%. For a Ti₍₁₋ₓ₎AlₓN film where x varies from 25% to 40% the etch rate selectivity of OSG to Ti₍₁₋ₓ₎AlₓN is approximately 15:1. Thus, the OSG layer will etch about fifteen times faster than the Ti₍₁₋ₓ₎AlₓN layer. Following the formation of the second hardmask layer 60, a layer of bottom antireflective coating (BARC) 70 and a photoresist layer 80 are formed and patterned as shown in Figure 1(a). The BARC layer 70 is an optional layer.

Shown in Figure 1(b) is the structure of Figure 1(a) following the etching of the BARC layer 70 and the second hardmask layer 60 with the remaining photoresist and BARC stripped. In an embodiment of the instant invention the Ti₍₁₋ₓ₎AlₓN second hardmask layer 60 is etched with a dry plasma etch process comprising BCl₃,Cl₂ and other additives such as N2 and Ar, and a plasma source power of approximately 800 Watts to 1500 Watts, and a bias power of approximately 50-250 Watts. The flow rates of BCl₃ and Cl₂ are 0-150 sccm and 50-200 sccm respectively and the chamber pressure is approximately 5 mTorr to 20 mTorr.

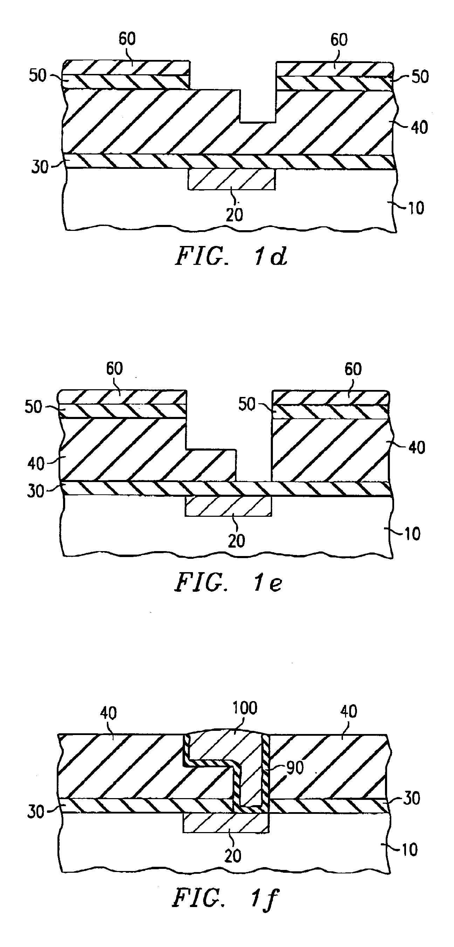

Following the etching of the second hardmask layer to define the metal trench pattern, the resist 80 and BARC 70 are stripped away in an oxygen-based plasma. Alternative plasma, such as H₂ and/or N₂, maybe used for photoresist strip. A wet clean is optional to remove possible residues. Following the clean processes, a second BARC layer 75 and a second photoresist layer 85 are formed and patterned on the structure of Figure 1(b) to define the first trench pattern as shown in Figure 1(c). Following the formation of the second patterned photoresist layer 85, BARC layer 75 is etched and the exposed portion of the first hardmask layer 50 and the underlying low k dielectric layer 40 are etched to form a first trench as shown in Figure 1(c). In the case of an OSG low k dielectric film, a C₄F₈/N₂/CO plasma based process can be used with flow rates of 5-10 sccm (C₄F₈), 50-300 sccm (N₂), and 50-200 sccm (CO) with a plasma power source of approximately 900 Watts to 2000 Watts. The photoresist layer 85 will be attacked during the etching processes and will be wholly or partially removed. Following the etching of the OSG film 40, the remaining photoresist layer 85, BARC layer 75, and exposed region of the first hardmask layer 50 are removed resulting in the structure illustrated in Figure 1(d). Alternatively, the photoresist layer 85 and BARC 75 can be stripped before the start of the etching of dielectric layer 40, to reduce the undesired impact to the low k dielectrics 40.

The exposed region of the low k dielectric layer is then etched as shown in Figure 1(e) to form a second trench structure which is positioned over the first trench structure. The exposed portion of the etch stop layer 30 is removed and a liner layer 90 and copper region 100 is formed as shown in Figure 1(f). Standard semiconductor process techniques can be used to form the liner layer 90 and copper region 100 such as film deposition and chemical mechanical polishing (CMP). In a further embodiment of the damascene process, the hardmask layers 50 and 60 can be removed using CMP. Typically the copper region 100 is formed by first forming a thick layer of copper followed by CMP processes to remove the excess copper. The removal of the hardmask layers 50 and 60 using CMP can be incorporated into this copper CMP removal process by changing the polishing conditions. In addition to copper any suitable conducting material can be used to fill the trench formed in the low k dielectric.

A further embodiment of the instant invention is shown in Figures 2(a) - 2(g). As shown in Figure 2(a) a first etch stop layer 30 is formed over a copper layer 20 and a first dielectric layer 10. The dielectric layer 10 is formed over a silicon substrate containing various electronic devices such as transistors, diodes, etc. The copper layer 20 represents a portion of the copper interconnect of an integrated circuit which is made up of the electronic devices contained in the silicon substrate. In a multi-level interconnect scheme, layers 10 and 20 described here generally represent the previous interconnect level. The first etch stop layer may comprise silicon nitride (SiN), silicon carbide (SiC), or any suitable material. Following formation of the etch stop layer 30, a first dielectric layer 42 with a low dielectric constant (i.e. less that 3.0) is formed over the etch stop layer 30. In an embodiment of the instant invention this low k dielectric layer 42 comprises organosilicate glass (OSG) which has a dielectric constant of about 2.8. In addition to OSG any suitable low k dielectric material may be used to form the first dielectric layer 42. Following the formation of the first low k dielectric layer 42, a second etch stop layer 110 is formed on the first low k dielectric layer 42. The second etch stop layer may comprise silicon nitride (SiN), silicon carbide (SiC), or any suitable material. A second low k dielectric film (i.e. dielectric constant less than 3.0) 44 is formed on the second etch stop layer 110. In an embodiment of the instant invention the second low k dielectric film will comprise OSG or other suitable materials. A first hardmask layer 50 is formed on the second low k dielectric film 44. This first hardmask layer 50 comprises a material selected from the group consisting of silicon carbide (SiC), silicon nitride (SiN), and any other suitable material. Following the formation of the first hardmask layer 50 a second hardmask layer 60 is formed on the first hardmask layer. This second hardmask layer comprises a material selected from the group consisting of titanium aluminide (TiAl), titanium aluminum nitride (TiAlN), titanium nitride (TiN), aluminum nitride (AlN), tantalum aluminide (TaAl), tantalum aluminum nitride (TaAlN), or any combination of layers of these various alloys. In an embodiment of the instant invention Ti₍₁₋ₓ₎AlₓN is used with x varying from 0 to 100% and more preferably from 25% to 40%. For a Ti₍₁₋ₓ₎AlₓN film where x varies from 25% to 40% the etch rate selectivity of OSG to Ti₍₁₋ₓ₎AlₓN is approximately 15:1. Thus, the OSG film will etch approximately fifteen times faster than the Ti₍₁₋ₓ₎AlₓN film. Following the formation of the second hardmask layer 60, a layer of bottom antireflective coating (BARC) 70 and a photoresist layer 80 is formed and patterned as shown in Figure 2(a). The BARC 70 is an optional layer.

Shown in Figure 2(b) is the structure of Figure 2(a) following the etching of the BARC layer 70 and the second hardmask layer 60 followed by resist and BARC stripping. In an embodiment of the instant invention the Ti₍₁₋ₓ₎AlₓN second hardmask layer 60 is etched with a dry plasma etch process comprising BCl₃, Cl₂ and other additives such as N2 and Ar, and a plasma source power of approximately 800 Watts to 1500 Watts, and a bias power of approximately 50-250 Watts. The flow rates of BCl₃ and Cl₂ are 0-150 sccm and 50-200 sccm, respectively and the chamber pressure is approximately 5-20 mTorr.

Following the etching of the second hardmask layer, the resist 80 and BARC 70 are stripped away in an oxygen-based plasma. Alternative plasma, such as H₂ and/or N₂, may also be used for photoresist strip. A wet clean is optional to remove possible residues. Following the clean processes a second BARC layer 75 and a second photoresist layer 85 are formed and patterned on the structure of Figure 2(b) as shown in Figure 2(c). Following the formation of the second patterned photoresist layer 85, the exposed portion of the first hardmask layer 50 is etched and the resist 85 and BARC 75 layers are stripped in an H₂ or N₂ plasma. Oxygen plasma may need to be avoided for resist strip if it changes the properties of the low k dielectric layer 44. A wet clean is optional after resist strip to remove any etch residues. In the case of via-to-trench misalignment, an additional second hardmask etch is needed prior to the first hardmask via opening etch.

Following the removal of the photoresist 85 and BARC 75 layers, the low k dielectric layer 44 is etched as shown in Figure 2(d). In the case of the second OSG low k dielectric film 44, a C₄F₈/N₂/CO plasma based process can be used with flow rates of 5-10 sccm C₄F₈, 50-300 sccm N₂, and 50-200 sccm CO with a plasma power source of approximately 900 Watts to 2000 Watts. The etch stops on the second etch stop layer 110, as shown in Fig. 2(d)

The exposed region of the second etch stop layer 110 and the exposed portion of the first hardmask 50 are now removed using the second hardmask 60 as etch mask as shown in Fig 2(e). The exposed portions of the low k dielectric layers 44 and 42 are then etched simultaneously. The etching process is completed when the etch stop layer 110 is reached in the trench portion and etch stop layer 30 is reached in the via portion as shown in Fig 2(f). The exposed portion of the etch stop layer 30 is removed, and the exposed portion of the trench etch stop layer 110 may be etched as well. A liner layer 90 and copper region 100 is formed as shown in Figure 2(g). Standard semiconductor process techniques can be used to form the liner layer 90 and copper region 100 such as film deposition and chemical mechanical polishing (CMP). In a further embodiment of the damascene process, the hardmask layers 50 and 60 can be removed using CMP. Typically the copper region 100 is formed by first forming a thick layer of copper followed by CMP processes to remove the excess copper. The removal of the hardmask layers 50 and 60 using CMP can be incorporated into this copper CMP removal process by changing the polishing conditions. In addition to copper, any suitable conducting material can be used to fill the various trench structures.

While this invention has been described with reference to illustrative embodiments, this description is not intended to be construed in a limiting sense. Various modifications and combinations of the illustrative embodiments, as well as other embodiments of the invention will be apparent to persons skilled in the art upon reference to the description. It is therefore intended that the appended claims encompass any such modifications or embodiments.

## Claims

1. A method for forming interconnects, comprising:
providing a silicon substrate containing one or more electronic devices;
forming a first dielectric layer over said silicon substrate;
forming a second dielectric layer over said first dielectric layer wherein the dielectric constant of the second dielectric layer is less that 3.0;
forming a first hardmask layer over said second dielectric layer;
forming a second hardmask layer on said first hardmask layer wherein said second hardmask layer comprises a material selected from the group consisting of titanium aluminide (TiAl), titanium aluminum nitride (TiAlN), titanium nitride (TiN), aluminum nitride (AlN), tantalum aluminide (TaAl), and tantalum aluminum nitride (TaAlN);
forming a trench in said second dielectric; and
filling said trench with a conducting material.

2. The method of claim 1 wherein said second dielectric layer is OSG.

3. The method of claim 1 or Claim 2 wherein said conducting material is copper.

4. The method of any preceding claim, wherein the material used to form the first hardmask layer is selected from the group consisting of silicon carbide and silicon nitride.

5. A method for forming interconnects, comprising:
providing a silicon substrate containing one or more electronic devices;
forming a first dielectric layer over said silicon substrate;
forming a second dielectric layer over said first dielectric layer wherein the dielectric constant of the second dielectric layer is less that 3.0;
forming a first hardmask layer over said second dielectric layer;
forming a second hardmask layer on said first hardmask layer wherein said second hardmask layer comprises a material selected from the group consisting of titanium aluminide (TiAl), titanium aluminum nitride (TiAlN), titanium nitride (TiN), aluminum nitride (AlN), tantalum aluminide (TaAl), and tantalum aluminum nitride (TaAlN);
etching a first opening in said second hardmask layer of a first width;
forming a first trench of a second width in said second dielectric layer wherein said second width is less than said first width;
etching a second opening in said first hardmask layer of a first width;
forming a second trench of a first width in said second dielectric layer wherein said second trench is positioned over said first trench; and
filling said first and second trench with a conducting material.

6. The method of claim 5 wherein said second dielectric layer is OSG.

7. The method of claim 5 or claim 6, wherein said conducting material is copper.

8. The method of claim 5, claim 6 or claim 7, wherein said first hardmask is a material selected from the group consisting of silicon nitride and silicon carbide.
